# DEMANDE DE BREVET EUROPEEN

(11) **EP 0 872 893 A1**
(43) Date de publication de la demande: **21.10.1998**
(21) Numéro de dépôt: 98410039.6
(22) Date de dépôt: 14.04.1998
(51) Int. Cl.: H01L 29/735

(54) **Transistor PNP latéral dans une technologie BICMOS**

(30) Priorité: 15.04.1997 FR 9704914
(71) Demandeur: SGS-THOMSON MICROELECTRONICS S.A., 94250 Gentilly (FR); FRANCE TELECOM, 75015 Paris (FR)
(72) Inventeur: Laurens, Michel, 38120 Saint Egrève (FR)
(74) Mandataire: de Beaumont, Michel

(57) **Abrégé**

L'invention concerne un transistor PNP latéral dans une technologie de fabrication de circuit intégré BICMOS comprenant une région d'émetteur (31) formée dans la surface supérieure d'une couche semiconductrice faiblement dopée et entourée d'un anneau de collecteur (32) formé dans la surface supérieure de ladite couche semiconductrice. La zone annulaire de la couche semiconductrice séparant l'émetteur de l'anneau de collecteur comprend une couche isolante (34) revêtue d'une couche de silicium polycristallin (35) sur les côtés de laquelle sont formées des espaceurs isolants (36).

## Description

La présente invention concerne la fabrication de circuits intégrés et plus particulièrement la réalisation d'un transistor PNP latéral dans une technologie de circuits intégrés prévoyant la coexistence de composants MOS et de composants bipolaires (technologie BICMOS).

On utilisera par exemple la technologie décrite dans la demande de brevet français de la demanderesse N° 97/02637 déposée le 28 février 1997 (B3308).

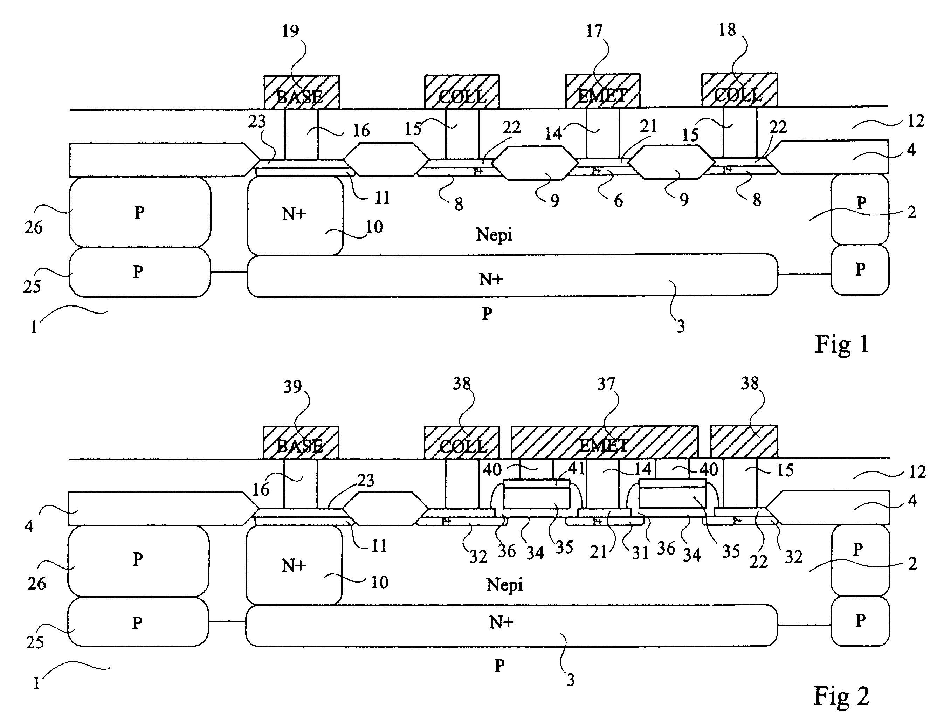

La figure 1 représente un exemple de transistor PNP latéral réalisable dans la technologie susmentionnée. La référence 1 désigne un substrat de type P, sur lequel est formée une couche épitaxiée 2 de type N. Dans la région où doit être formé le transistor PNP, une couche enterrée 3 de type N⁺ est formée entre le substrat et la couche épitaxiée. Les différentes zones du composant sont délimitées par des portions d'une région d'oxyde épais 4. Dans la technologie envisagée, où la définition d'un masque peut être de l'ordre de 0,3 à 0,5 µm, la couche épitaxiée aura une épaisseur de l'ordre de 1 micromètre et la couche d'oxyde épais une épaisseur de l'ordre de 0,6 µm. On notera donc que la figure n'est pas réalisée à l'échelle, comme cela est classique dans le domaine de la représentation des composants semiconducteurs.

Dans la couche épitaxiée de type N est formée une région d'émetteur 6 fortement dopée de type P entourée d'une région annulaire de collecteur 8 également fortement dopée de type P. La région d'émetteur est entourée d'un anneau 9 de la région d'oxyde épais 4. Une diffusion profonde 10 de type N assure la liaison entre la couche enterrée 3 et une région superficielle 11 fortement dopée de type N constituant une région de reprise de contact de base. L'ensemble de la structure est recouvert d'une couche isolante planarisée 12 à travers laquelle sont formées des vias 14, 15 et 16 de contact avec l'émetteur, le collecteur et la base, respectivement recouverts de métallisations 17, 18 et 19. Pour améliorer la qualité des contacts, chacune des régions d'émetteur, de collecteur et de base 6, 8 et il est revêtue en surface d'une région de siliciure, par exemple de siliciure de titane, respectivement 21, 22 et 23.

De préférence, dans des buts d'isolement, l'ensemble de la structure est entouré d'une couche enterrée 25 de type P surmontée d'une région diffusée 26 de type P s'étendant de la couche enterrée à la surface de la couche épitaxiée.

On s'aperçoit en pratique qu'un tel transistor PNP latéral présente un gain peu élevé.

La présente invention vise à obtenir un transistor PNP latéral de gain plus élevé que celui décrit précédemment.

Un autre objet de la présente invention est de prévoir un tel transistor PNP obtenu sans augmenter le nombre et la nature des étapes de fabrication utilisées dans la technologie de fabrication susmentionnée.

Pour atteindre ces objets, la présente invention prévoit un transistor PNP latéral dans une technologie de fabrication de circuit intégré BICMOS comprenant une région d'émetteur formée dans la surface supérieure d'une couche semiconductrice faiblement dopée et entourée d'un anneau de collecteur formé dans la surface supérieure de ladite couche semiconductrice, dans lequel la zone annulaire de la couche semiconductrice séparant l'émetteur de l'anneau de collecteur comprend une couche isolante revêtue d'une couche de silicium polycristallin sur les côtés de laquelle sont formées des espaceurs isolants.

Selon un mode de réalisation de la présente invention, les zones d'émetteur et de collecteur sont revêtues de régions de siliciure métalliques.

Selon un mode de réalisation de la présente invention, un contact d'émetteur est relié à ladite couche de silicium polycristallin.

Selon un mode de réalisation de la présente invention, ladite couche semiconductrice est une couche épitaxiée d'un premier type de conductivité formée sur une plaquette de silicium monocristallin du type de conductivité opposé, une couche enterrée du premier type de conductivité et de fort niveau de dopage étant réalisée à l'interface entre le substrat et la couche épitaxiée et étant reliée à la surface par l'intermédiaire d'une couche du premier type de conductivité fortement dopée reliée à un contact de base.

La présente invention prévoit aussi un procédé de fabrication du transistor PNP latéral susmentionné comprenant les étapes consistant à délimiter par un oxyde épais une zone d'émetteur-collecteur ; déposer une couche d'un matériau isolant ; déposer une couche de silicium polycristallin ; graver la couche de silicium polycristallin sensiblement selon le contour de la zone de séparation entre émetteur et collecteur ; former des espaceurs isolants de part et d'autre de la couche de silicium polycristallin ; et procéder aux implantations d'émetteur et de collecteur.

Selon un mode de réalisation de la présente invention, ce procédé comprend en outre les étapes consistant à procéder à une étape de siliciuration ; déposer une couche d'un oxyde épais ; former des vias de contact avec les régions d'émetteur et de collecteur, et un via de contact avec la surface supérieure de la couche de silicium polycristallin ; et relier par une métallisation les vias d'émetteur et de silicium polycristallin.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe schématique d'un transistor PNP latéral classique ; et
la figure 2 est une vue en coupe schématique d'un transistor PNP latéral selon la présente invention.

Comme le représente la figure 2, le transistor PNP latéral selon la présente invention est formé dans une couche épitaxiée 2 au-dessus d'un substrat 1, dans une région où a été préalablement formée une couche enterrée 3 de type N. Le contact de base est repris par une région 10 dopée de type N formant la liaison entre la couche enterrée 3 et une région de base 11 surmontée d'une couche de siliciure 23. L'émetteur est constitué d'une région dopée de type P 31 entourée d'une région de collecteur en anneau de type P 32.

La différence essentielle avec la structure de la figure 1 réside dans la nature de l'anneau formé au-dessus de la couche épitaxiale entre l'émetteur et le collecteur. Cet anneau est constitué d'une couche isolante 34 relativement épaisse, c'est-à-dire plus épaisse que la couche d'isolement de grille d'un transistor MOS, sur laquelle est formée une couche de silicium polycristallin 35 encadrée d'espaceurs 36 en un matériau isolant. Ensuite, comme dans le procédé antérieur, les régions d'émetteur, de base et de collecteur sont connectées à des métallisations d'émetteur, de base et de collecteur 37, 38 et 39 par l'intermédiaire de vias 14, 15 et 16 et chacune des régions d'émetteur, de collecteur et de base est revêtue d'une couche d'un siliciure métallique, respectivement 21, 22, 23. On notera que la métallisation d'émetteur 37 est également de préférence reliée par des vias 40 à la surface supérieure de la couche de silicium polycristallin 35, celle-ci étant couramment revêtue d'une couche de siliciure 41. Cette connexion n'a pas de rôle particulier dans le fonctionnement du dispositif mais est seulement destinée à éviter de laisser flottant l'anneau de silicium polycristallin 35. En effet, si celui-ci était laissé flottant, il pourrait se charger sous l'effet de phénomènes parasites et provoquer l'apparition d'un canal entre émetteur et collecteur.

Les étapes principales de fabrication du dispositif illustré en figure 2 sont les suivantes :
formation des couches enterrées 3 et 25 ;
formation de la couche épitaxiée 2 ;
formation des caissons P 26 ;
formation des régions d'oxyde épais 4 ;
dopage de la région 10 de puits de base ;
dépôt de la couche d'isolement 34 (épaisseur de l'ordre de 100 nm)
dépôt d'une couche de silicium polycristallin ;
gravure de cette couche pour délimiter les régions 35 ;
gravure de la couche d'isolement 34 ;
formation des espaceurs 36 ;
implantation de la région N⁺ 11 ;
implantation des régions P⁺ 31 et 32 ;
recuit thermique rapide ;
formation des régions de siliciure 21, 22, 23, 41 ;
dépôt de la couche d'isolement superficielle 12
formation des vias et des métallisations.

La couche d'isolement 34 et les espaceurs 36 peuvent être en tout isolant approprié, par exemple en oxyde de silicium ou en nitrure de silicium.

Une caractéristique du transistor PNP latéral selon la présente invention est que, comme on le voit en figure 2, la zone de base active entre émetteur et collecteur est située au voisinage immédiat de la surface supérieure de la couche épitaxiée 2. Par contre, dans le cas de la figure 1, cette zone s'étend sous l'oxyde épais 9, c'est-à-dire à environ 300 nm sous le niveau de la surface de la couche épitaxiée. Ceci constitue un premier avantage de la présente invention car, en pratique, la couche épitaxiée 2 ne présente pas un niveau de dopage homogène mais présente un gradient de dopage entre sa surface supérieure et sa surface inférieure, ce gradient étant dû à une exodiffusion inévitable des dopants contenus dans la couche enterrée 3 pendant la croissance de cette couche épitaxiée. Etant donné que, selon la présente invention, la base intrinsèque est plus éloignée de la couche enterrée, elle correspondra à une région moins dopée, ce qui, de façon connue, contribue à l'augmentation du gain d'un transistor.

Une autre caractéristique de la présente invention est que, lors du recuit des diffusions d'émetteur et de collecteur, les implantations préalablement réalisées s'étendront latéralement sous les espaceurs 36 d'une quantité sensiblement égale à la profondeur de jonction. Par contre, dans le cas de la figure 1, l'extension latérale des régions P⁺ d'émetteur et de collecteur est bloquée par la présence de l'oxyde épais 9. Ceci constitue un autre avantage de l'invention car, lors de l'étape ultérieure de siliciuration, une partie du dopant de l'émetteur et du collecteur tend à diffuser vers la région de siliciure et le dopage de la région située sous le siliciure diminue. Avec la structure selon l'invention, étant donné que les régions de collecteur et d'émetteur présentent des zones en regard débordant par rapport à la zone siliciurée, ces zones en regard, qui sont pour l'émetteur les zones actives en ce qui concerne l'injection, ne seront pas appauvries. Ceci contribue également à augmenter le gain du transistor. Selon l'invention, ce gain peut augmenter de 30 %.

Un autre avantage du transistor selon la présente invention est que sa fabrication est parfaitement compatible avec la fabrication d'un transistor NPN en technologie BICMOS tel qu'exposé dans la demande de brevet susmentionnée. Notamment, la couche de silicium polycristallin 35 de la figure 2 correspondra à la couche de silicium polycristallin à partir de laquelle est diffusée l'émetteur du transistor NPN. De même, la couche d'isolant 34 séparant la couche de silicium polycristallin de la couche semiconductrice faiblement dopée 2 est la même que celle séparant le silicium polycristallin de l'émetteur de la zone de base faiblement dopée P du transistor NPN.

Bien entendu, la présente invention est susceptible de diverses variantes et modifications qui apparaîtront à l'homme de l'art. Notamment en ce qui concerne les dimensions et la nature des matériaux utilisés.

## Revendications

1. Transistor PNP latéral dans une technologie de fabrication de circuit intégré BICMOS comprenant une région d'émetteur (31) formée dans la surface supérieure d'une couche semiconductrice faiblement dopée et entourée d'un anneau de collecteur (32) formé dans la surface supérieure de ladite couche semiconductrice, caractérisé en ce que la zone annulaire de la couche semiconductrice séparant l'émetteur de l'anneau de collecteur comprend une couche isolante (34) revêtue d'une couche de silicium polycristallin (35) sur les côtés de laquelle sont formées des espaceurs isolants (36).

2. Transistor PNP latéral selon la revendication 1, caractérisé en ce que les zones d'émetteur et de collecteur sont revêtues de régions de siliciure métalliques (21, 22).

3. Transistor PNP latéral selon la revendication 2, dans lequel un contact d'émetteur (37) est relié à ladite couche de silicium polycristallin.

4. Transistor PNP latéral selon la revendication 1, caractérisé en ce que ladite couche semiconductrice est une couche épitaxiée (2) d'un premier type de conductivité formée sur une plaquette de silicium monocristallin (1) du type de conductivité opposé, une couche enterrée (3) du premier type de conductivité et de fort niveau de dopage étant réalisée à l'interface entre le substrat et la couche épitaxiée et étant reliée à la surface par l'intermédiaire d'une couche (10) du premier type de conductivité fortement dopée reliée à un contact de base (11).

5. Procédé de fabrication d'un transistor PNP latéral selon l'une quelconque des revendications précédentes, caractérisé en ce qu'il comprend les étapes suivantes :
délimiter par un oxyde épais (4) une zone d'émetteur-collecteur ;
déposer une couche d'un matériau isolant (34) ;
déposer une couche de silicium polycristallin (35) ;
graver la couche de silicium polycristallin sensiblement selon le contour de la zone de séparation entre émetteur et collecteur ;
former des espaceurs isolants (36) de part et d'autre de la couche de silicium polycristallin ; et
procéder aux implantations d'émetteur et de collecteur.

6. Procédé selon la revendication 5, caractérisé en ce qu'il comprend en outre les étapes suivantes :
procéder à une étape de siliciuration ;
déposer une couche d'un oxyde épais (12) ;
former des vias de contact (14, 15) avec les régions d'émetteur et de collecteur (31, 32), et un via de contact (40) avec la surface supérieure de la couche de silicium polycristallin ;
relier par une métallisation (37) les vias d'émetteur et de silicium polycristallin.
